Europäisches Patentamt

European Patent Office

Office européen des brevets

(19)

(11) Publication number: **0 100 079**
**A2**

## (12) EUROPEAN PATENT APPLICATION

(21) Application number: **83107228.5**

(51) Int. Cl.³: **G 03 F 7/26**

(22) Date of filing: **22.07.83**

(30) Priority: **26.07.82 US 403242**

(43) Date of publication of application: **08.02.84**
**Bulletin 84/6**

(84) Designated Contracting States: **DE FR GB NL**

(71) Applicant: **THE PERKIN-ELMER CORPORATION, Main Avenue, Norwalk Connecticut 06856 (US)**

(72) Inventor: **Reinberg, Alan R., Charberth Lane, Westport Connecticut 06880 (US)**
Inventor: **Steinberg, George N., 17 Jennings Ct, Westport Connecticut 06880 (US)**
Inventor: **Zarowin, Charles B., 7 Topsail Road, Rowayton Connecticut 06853 (US)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22 (DE)**

(54) **Dry resist development using downstream plasma generation.**

(57) A method for the dry development of photoresist. The photoresist coating of a silicon wafer is developed by the chemical reaction with the active species of a remotely generated plasma.

EP 0 100 079 A2

PATENTANWÄLTE
GRÜNECKER · DR. KINKELDEY · DR. STOCKMAIR
DR. SCHUMANN · JAKOB · DR. BEZOLD · MEISTER
HILGERS · DR. MEYER-PLATH
MAXIMILIANSTR. 58 · 8000 MÜNCHEN 22

## BACKGROUND OF THE INVENTION

An important step in the manufacture of integrated circuits is the development of the photoresist layer formed on a silicon wafer. Such development removes photoresist from the wafer in accordance with a pattern formed thereon by the previous exposure of the photoresist to a source of radiation through a mask. As is well known the development step may be required a number of times before the circuit on each chip-size area of the wafer is completely formed.

One development method entails the use of liquid developers which by suitable means is made to react with the photoresist until development is completed. This technique is slow, requires costly hardware for the application of the liquid and requires elaborate arrangements for the disposal of the used liquid chemical.

In view of the problems associated with wet chemical development of photoresists, methods of development utilizing dry chemicals are being explored by the industry. Such methods use techniques similar to those used in the plasma etching systems. In these methods the reactive species produced i a plasma generating unit chemically react with the photoresist to accomplish development.

One known method of dry development utilizes a barrel plasma reactor technique wherein a plurality of wafers are placed in a cylinder into which the active species of the plasma are introduced. While this technique eliminates many of the problems associated with wet chemical development, it too, has disadvantages. For example, since it is a batch type process, i.e., develops many wafers simultaneously, the uniformity of development varies from wafer to wafer. This is so since each wafer is different, e.g., amount and distribution of the photoresist coating may differ from wafer to wafer and the distribution of active species may be non-uniform. In addition, the plasma excitation of such barrel systems is non-uniform further producing wafer to wafer nonuniformities.

Alternately, batch planar reactors may be used. These, however, subject the wafers to high energy ion bombardment which limits the selectivity for development between the exposed and unexposed portions.

One at a time planar reactors may also be used but considerable ion-bombardment occurs with its attendant artifacts.

The method of the present invention overcomes the foregoing disadvantages by developing wafers one at a time in a downstream chemical reactor without ion bombardment. Since each wafer is processed individually, uniformity of development is excellent. In addition, heat sinking of the wafers is easily accomplished inasmuch as one wafer at a time occupies the development chamber which need be made only large enough to accommodate a single wafer. The present invention also processes wafers faster than the batch processing technique above described.

## BRIEF SUMMARY OF THE INVENTION

The present invention relates to a method for the dry development of photoresist. In carrying out the method of the present invention a plasma is generated at a remote location and the gas is transported to the wafer to be developed to cause the active species to chemically react with the photoresist on the wafer until development is complete. The present method is capable of being carried out in any typical plasma etching system employing the concept of downstream etching wherein the plasma is generated at a location remote to the actual reaction location. This permits the developing to be purely a dry chemical reaction without the ion bombardment that takes place in the plasma generating region. Since ion bombardment removes exposed and unexposed photoresist at essentially equal rates, this method improves the development rate ratios.

More specifically, the method of the present invention comprises the steps of flowing a combination of gases at specified rates through the plasma generating area of a downstream system, maintaining the system at an appropriate power and frequency to generate a plasma, transporting the active species of the plasma to the developing area for reaction with the photoresist to develop the photoresist. The parameters of the steps are dependent on the particular type of system used to carry out the method.

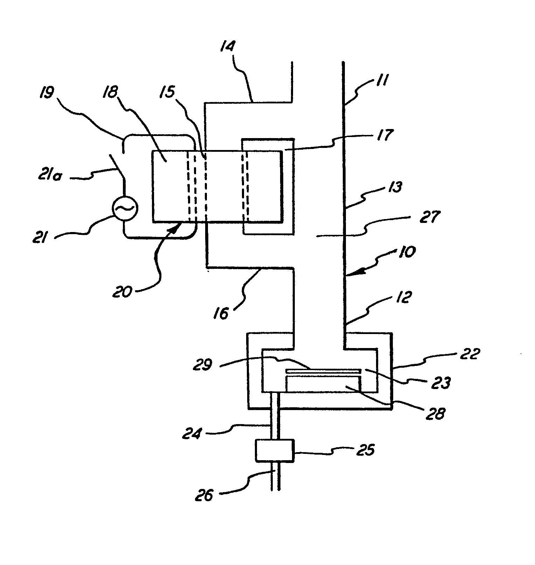

## BRIEF DESCRIPTION OF THE DRAWING

The Figure illustrates an inductively coupled system of a type capable of carrying out the method of the present invention.

## DESCRIPTION OF THE INVENTION

Referring now to the Figure there is shown a tube structure 10. The tube structure 10 may be made of quartz or any similar non-conductive glass, ceramic or heat resistant plastic material. The tube structure comprises a gas inlet portion 11 and a gas outlet portion 12.

The gas inlet 11 is normally connected to a source (not shown) of development gas or gases while the outlet portion 12 is connected to a pump or vacuum source. Other means (not shown) normally regulate the flow rate of gas in and spent gas out and maintain the pressure within the tube structure at some desired value. Such a flow rate and pressure control means is described in U.S. Application Serial No. 223,175 entitled "Molar Gas-Flow Controller", having the same assignee as the present application.

The tube structure 10 comprises four legs 13, 14, 15 and 16 which form a continuous closed path around an opening 17. The tube structure 10 is topologically toroidal. The essential feature is that the gas discharge current path therein be in a complete loop, around the central opening to which the magnetic fluxes of primary and secondary are linked.

Disposed through the opening 17 and encircling leg 15 of the tube structure 10 is a transformer core 18 made of · magnetic material such as ferrite or similar magnetically permeable material.

A primary winding 19 of one or more turns is looped about core 18. The continuous path formed about the core 18 by the tube structure 10 acts as a secondary winding thus completing a transformer 20.

The primary winding 19 is connected to a source 21 of A.C. voltage via switch 21a so that when switch 21a is closed a secondary current is caused to flow about the continuous loop of legs 13, 14, 15 and 16. This current generates a plasma from the gases within the loop volume wherein, for example, etching of films on silicon wafers may be performed.

The foregoing describes a system in which the power source is inductively coupled to the plasma generating apparatus.

Other generation methods are also possible such as capacitively coupled R.F. discharges or microwave activated discharges.

The embodiment of the Figure is essentially designed for downstream etching or developing wherein the reactive species of the generated plasma is transported downstream from the plasma chamber to a remote etching or stripping chamber.

A key feature of the current invention is that the development is carried out completely in the absence of ion bombardment. Ion bombardment produces physical sputtering which is much less chemically selective, between the exposed and unexposed regions of the resist. Thus greater selectivity can be obtained between these two regions.

Thus, in the embodiment of the Figure, inner volume 23 of chamber 22 communicates with the plasma chamber 27 of tube structure 10 via outlet portion 12. The inner volume 23 of chamber 22 is connected to a pump 25 by port 24 for evacuating gases via port 26 maintaining pressure within volume 23 and in the plasma chamber 27 at a value suitable for developing. Pump 25 also causes the active species generated in volume 27 to be transported to volume 23 where photoresist development may be performed. Chamber 22 has disposed therein a platform 28 for supporting a wafer 29 whose photoresist is to be developed. Platform 28 may be made of heat conducting material such as aluminum to provide a thermal sink for the wafer 29. This is important because the developing rate is temperature dependent. Thus, a uniform temperature of the wafer is desirable.

The foregoing described apparatus is described in U.S. Application SN 298,416 filed on September 1, 1981 having the same assignee as the present application. While the above described apparatus is ideally suited for carrying out the method of the present invention other downstream systems also be used. For example, the downstream etching system which utilizes a helical resonator to generate the plasma may also be used. Such a system is described in U.S. Patent Application SN 290,270 filed August 5, 1981 and having the same assignee as the present application.

The method of the present invention was conceived as a method for development of certain negative photoresists, e.g., of the type available from the Hercules Corporation of Wilmington, Delaware, the types designated MER-D-47 and MER-D-50.

In the inductive system described in reference to the Figure a mixture of carbon tetrafluoride $CF_4$ and oxygen $O_2$ are introduced simultaneously into plasma chamber 27 via inlet 11 where a plasma is generated by application of an R.F. source to primary winding 19. Reactive species of the gases are transported to chamber 23 due to the action of pump 25 and exhausted through port 26. Pressure in chamber 23 is controlled by the amount of gas entering the chamber 23 versus the amount leaving.

An example of typical operating parameters for development of photoresists comprise flow rates of $O_2$ and $CF_4$ through the system of 155 and 33 cubic centimeters per minute, respectively. Operating pressure within chamber 23 is maintained at 0.35 Torr with 300 watts of power into the inductive discharge at 400 $KH_z$. Such example can develop more than 100 wafers per hour, with an average development time per wafer of 30 seconds.

While the foregoing identifies $CF_4$ as one of the gases used in photoresist development, it is pointed out that any gas in the family of $C_xF_y$ which produce fluorine may be used. For example, $C_2F_6$ may be used in place of $CF_4$.

Although the above example sets forth typical operating parameters, the system produces acceptable results when the parameters are in the following ranges. Gas flow may range

between 100-1000 $O_2$ cubic centimeters per minute and 10-500 $CF_4$ cubic centimeters per minute represent effective ranges. The pressure in the developing chamber can be within the range of 0.1 to 1 Torr. The RF generating power may range from 100 to 1000 watts with the frequency of the RF source ranging between 10 $KH_z$ to 27 $MH_z$. Varying ratios of $CF_4$ to $O_2$ may be used. In a practical embodiment a ratio of 4.5 to 1 of $O_2$ to $CF_4$ has been found to be particularly useful.

For the helical resonator system described in the aforementioned U.S. Application SN 290,270, typical operating parameters for photoresist development are flow rates of $CF_4$ and $O_2$ of 15 and 155 cubic centimeters per minute, respectively. Operating pressure in the system is maintained at 0.35 Torr with 300 watts of power into the resonator discharge at 13.56 $MH_z$.

A novel feature of the downstream process is that during development light is emitted from the reaction of the radials and photoresist.

Completion of the development process is determined by cessation of the optical light emission which exists as a byproduct of the active species of the gas reacting with the photoresist to be removed. When the light stops being emitted, the process is complete because the photoresist with which the active species reacts has been removed. A photodetector which is sensitive in the spectrum in which the light is emitted during photoresist development may be used with appropriate filters to detect the end of the development process. The photodetector may be used in association with other means to signal end of the process, cause the system to be cleansed of used gases and initiate the process after the developed wafer is replaced with a new undeveloped wafer.

MI 0100079

Other modifications of the present invention are possible in light of the above description which should not be deemed as limiting the invention beyond those limitations set forth in the claims which follow:

WHAT IS CLAIMED IS:

1.  A method for the dry development of photoresist, comprising the steps of,

introducing a fluorine producing gas and oxygen or oxygen containing gas to a plasma generating region,

generating a plasma of the gases in said plasma generating region,

transporting said gases to a photoresist developing region remote from said plasma generating region,

placing a photoresist coated wafer in said photoresist developing region where said gases chemically remove selected portions of photoresist from said wafer,

detecting the end of the chemical reaction of the gases on the photoresist,

maintaining the pressure within said developing region within a predetermined range.

2.  The method according to claim 1 further comprising the step of,

inductively coupling an R.F. power source to said plasma generating region.

3.  The method according to claim 2 wherein the frequency of said inductively coupled R.F. power is in the range 10 $KH_z$ to 1 $MH_z$.

4.  The method according to claim 3 wherein the power applied to the plasma generating region is in the range of 100 to 1000 watts.

5.  The method according to claim 4 wherein the fluorine producing gas is carbon tetrafloride.

6.  The method according to claim 5 wherein the flow of carbon tetrafluoride is in the range of 10-500 cubic centimeters per minute and the flow of oxygen is in the range of 100 to 1000 cubic centimeters per minute.

7.  The method according to claim 6 wherein the ratio of oxygen to carbon tetrafluoride flow is approximately 4.5.

8.  The method according to claim 2 further comprising the steps of,

maintaining the pressure in the developing region at 0.35 Torr,

maintaining the frequency of the RF power at 400 $KH_z$,

maintaining the power applied to the plasma generating region at 300 watts,

flowing oxygen and carbon tetrafluoride at rates of about 155 cubic centimeters per minute and 33 cubic centimeters per minute, respectively.

9.  The method according to claim 1 further comprising the step of;

connecting an RF source of power to the plasma generating region by means of a helical resonator.

10.  The method according to claim 9 further comprising the steps of;

maintaining the pressure in the developing region at 0.35 Torr,

maintaining the frequency of the RF power at 13.56 $MH_z$.

maintaining the power applied to the plasma generating region at 300 watts,

flowing carbon tetrafluoride and oxygen at rates of about 15 and 155 cubic centimeters per minute, respectively.

0100079

1/1